# EUROPÄISCHE PATENTSCHRIFT

(11) **EP 1 578 180 B1**
(45) Veröffentlichungstag und Bekanntmachung des Hinweises auf die Patenterteilung: **03.10.2007**
(21) Anmeldenummer: 04006522.9
(22) Anmeldetag: 18.03.2004
(51) Int. Cl.: H05K 5/00, H05K 7/20

(54) **Netzgerät**
Power supply pack
Bloc d'alimentation

(43) Veröffentlichungstag der Anmeldung: 21.09.2005
(73) Patentinhaber: Murrelektronik GmbH, 71570 Oppenweiler (DE)
(72) Erfinder: Gutekunst, Jürgen, 72622 Nürtingen (DE)
(74) Vertreter: Wasmuth, Rolf

(56) Entgegenhaltungen:
- EP-A- 0 740 499
- EP-A- 1 073 323
- DE-A- 1 815 041
- GB-A- 1 514 865

## Beschreibung

Die Erfindung betrifft ein Einbaunetzgerät zum Einbau in einen Schaltschrank oder dergleichen mit den Merkmalen nach dem Oberbegriff des Anspruchs 1.

Insbesondere im industriellen Bereich werden Einbaunetzgeräte eingesetzt, die eine Eingangsspannung bedarfsweise in eine oder mehrere verschiedene Ausgangsspannungen zur Versorgung elektrischer Verbraucher transformieren. Derartige Einbaunetzgeräte werden in Schaltschränken oder vergleichbaren Montageeinrichtungen eingebaut, wobei beispielsweise Schnappverbindungen zur Befestigung auf einer Montageschiene des Schaltschrankes vorgesehen sein können. Die Montageschienen sind standardisiert ausgeführt, so daß ein Einbaunetzgerät in Reihe mit vergleichbaren Netzgeräten oder anderen elektrischen Einrichtungen wie Sicherungsschalter oder dergleichen nebeneinander auf der Schiene angeordnet werden können.

Im Betrieb wird in Einbaunetzgeräten Verlustleistung erzeugt und in Form von Wärme freigesetzt. Zur Abfuhr der Wärme und zur Vermeidung einer Überhitzung sind bezogen auf die vorgesehene Einbauposition im Bereich einer unteren und einer oberen Wand Belüftungsöffnungen vorgesehen. Durch diese bildet sich ein kühlender Konvektionsstrom aus, der bei ausreichendem Seitenabstand des Netzgerätes zu anderen Wärmequellen zur Kühlung ausreichend sein kann.

Aus der DE 7044973 U ist eine Anordnung von nebeneinander auf einer Montageschiene angeordneten Selbstschaltern bekannt. Zur Verbesserung der Kühlung werden als Einzelteile ausgebildete Abstandshalter vorgeschlagen, die an die äußere Kontur der einzelnen Selbstschalter angepaßt sind. Die Abstandshalter werden als Einzelteile auf die Montageschiene aufgeclipst, was den Montageaufwand erhöht. Die Anpassung an die Kontur der Selbstschalter erschwert die Ausbildung einer kühlenden Luftströmung.

Der Erfindung liegt die Aufgabe zugrunde, ein Einbaunetzgerät der eingangs beschriebenen Gattung derart weiterzubilden, daß eine bessere Kühlwirkung sichergestellt ist.

Zur Lösung der Aufgabe wird ein Einbaunetzgerät vorgeschlagen, bei dem im Bereich mindestens einer seiner beiden Seitenwände mindestens ein Abstandshalter angeordnet ist. Durch den Abstandshalter ist sichergestellt, daß die zugehörige Seitenwand in montierter Position des Netzgeräts einen Mindestabstand zu einem benachbarten Gerät oder einem anderen seitlich angeordneten Bauteil aufweist. Durch den Mindestabstand ist auf der Außenseite der zugehörigen Seitenwand ein Freiraum vorgegeben, über den frei werdende Wärme an eine Luftströmung abgegeben werden kann. Durch die Erwärmung der Seitenwand entsteht ein Konvektionsstrom, der sowohl außenseitig als auch innenseitig an der Seitenwand vorbeiführt und eine beidseitige Kühlung bewirkt, so daß ausreichend Wärmeenergie abgegeben werden kann. Überhitzungserscheinungen können selbst in voll bestückten Schaltschränken zuverlässig vermieden werden. Die Erfindung ist als Einbaunetzgerät beschrieben; darunter können auch Gehäuse verstanden werden, die andere Verlustleistung erzeugende Einbauten haben und die ebenfalls entsprechend zu kühlen sind. Derartige Einbauten können Relais, Ventile oder elektronische Leistungsgruppen sein.

In einer zweckmäßigen Weiterbildung ist im Bereich beider Seitenwände mindestens je ein Abstandshalter vorgesehen. Die beiden Abstandshalter können dabei in ihrer seitlich gerichteten Höhe so bemessen sein, daß der vorgegebene minimale Freiraum an die zu erwartende Verlustleistung des Netzgeräts angepaßt ist. Es können auf beiden Seiten auch andere Geräte wie Sicherungsschalter angeordnet werden, wobei der Abstandshalter am Gehäuse des Netzgerätes eine ausreichende Kühlluftzirkulation für das Netzgerätgehäuse sicherstellt.

Vorteilhaft weist der Abstandshalter bezogen auf eine durch die vorgesehene Einbaulage vorgegebene Hochrichtung eine Längserstreckung auf, die insbesondere mindestens etwa ein Drittel einer Höhe der zugehörigen Seitenwand beträgt. Durch die genannte Längserstreckung ist sichergestellt, daß zwei Abstandshalter zweier benachbarter Geräte auch bei Fluchtungsfehlern zuverlässig aneinander anliegen. Bei benachbarten Geräten oder Bauteilen mit einer unebenen Seitenkontur ist sichergestellt, daß der jeweilige Abstandshalter mit einem erhabenen Bereich der Seitenkontur zur Anlage kommt. Eine zufällig sich einstellende Montagelage in einem vertieften seitlichen Bereich des Nachbargerätes ist vermieden. Ein montagebedingtes Unterschreiten des konstruktiv vorgegebenen seitlichen Minimalabstandes ist zuverlässig verhindert.

In einer vorteilhaften Ausbildung ist der Abstandshalter bezogen auf die Hochrichtung zumindest in etwa mittig an der zugehörigen Seitenwand angeordnet. Seitliche Berührungskräfte am Abstandshalter werden zumindest näherungsweise zentrisch in das Gehäuse eingeleitet. Ein Kippen bzw. ein Verkanten bei der Montage ist vermieden. Zweckmäßig sind zwei im Bereich der beiden sich gegenüberliegenden Seitenwände angeordnete Abstandshalter bezogen auf die Hochrichtung zumindest etwa in gleicher Höhe angeordnet. Insbesondere in Verbindung mit einer in diesem Bereich mittig verlaufenden Montageschiene ergibt sich eine zentrische Krafteinleitung in die Abstandshalter, denen zumindest etwa zentrische Kräfte an der Montageschiene entgegenwirken. Eine kippfreie Montage ist erleichtert.

In einer weiteren Ausführung sind zwei auf sich gegenüberliegenden Seitenwänden angeordnete Abstandshalter bezogen auf die Hochrichtung derart gegeneinander höhenversetzt angeordnet, daß die einander zugewandten Abstandshalter in Montagelage übereinander liegen. Die sich senkrecht zur Seitenwand erstreckende Höhe der Abstandshalter kann dabei so gewählt sein, daß die Höhe der zur Kühlung erforderlichen doppelten Spaltbreite entspricht.

Sofern zwei Netzgeräte vergleichbarer Bauart nebeneinander angeordnet werden, ergibt sich im Bereich der aneinander angrenzenden Seitenwände ein erhöhter Bedarf an Kühlleistung. Diesem Umstand ist durch die konstruktiv vorgegebene seitliche Höhe des Abstandshalters Rechnung getragen, ohne daß die zwei Abstandshalter der beiden benachbarten Netzgeräte aneinander anliegen.

In einer vorteilhaften Ausführung weist das Netzgerät eine Montagewand auf, wobei der Abstandshalter in einem Eckbereich zwischen der zugehörigen Seitenwand und der Montagewand angeordnet ist. Bereits beim Einschieben des Netzgeräts in Richtung der zugehörigen Montageschiene wirkt der Abstandshalter und führt das Netzgerät beispielsweise zwischen zwei vormontierten Geräten im vorgesehenen Abstand hindurch. Ein anschließendes Einrasten an der Montageschiene erfolgt in zentrierter Position. Eine nachträgliche Korrektur der seitlichen Lage ist nicht erforderlich.

Zur Vereinfachung der Montage weist der Abstandshalter bezogen auf die Montagerichtung des Netzgeräts eine vorderseitige Montageschräge auf. Ein nachträglich einzubauendes Nachbargerät mit oder ohne eigenem Abstandshalter braucht nur grob vorpositioniert werden und gleitet beim Einschieben auf der Montageschräge in die vorgesehene seitliche Abstandsposition.

In einer zweckmäßigen Weiterbildung ist der Abstandshalter mit einer Anlagefläche zur Abstützung gegen die Montageschiene versehen. Durch die seitlich über die Kontur des Netzgerätgehäuses hervorstehende Bauweise der Abstandshalter liegt auch die Anlagefläche seitlich weit außen. Insbesondere in Verbindung mit zwei symmetrisch sich gegenüberliegenden Anlageflächen zweier Abstandshalter ergibt sich eine in der Breite ausgedehnte Abstützung des Netzgeräts gegen die Montageschiene. Ein seitliches Verkippen ist vermieden.

Der Abstandshalter weist dabei zweckmäßig eine Nut mit insbesondere drei winklig zueinander liegenden, die Montageschiene zumindest teilweise umschließenden Anlageflächen auf. Es ergibt sich eine formflüssige Festlegung des Netzgeräts an der Montageschiene mit einer kippfreien Abstützung in mehreren Raumrichtungen.

Ausführungsbeispiele der Erfindung sind im Folgenden anhand der Zeichnung näher beschrieben. Es zeigen:
- Fig. 1: in einer perspektivischen Übersichtsdarstellung ein Einbaunetzgerät mit seitlichen Abstandshaltern im Bereich einer Montageschiene;
- Fig. 2: eine Rückansicht des Netzgeräts nach Fig. 1 mit Einzelheiten der Befestigung an der Montageschiene;
- Fig. 3: in einer Frontansicht zwei benachbart zueinander angeordnete Netzgeräte nach den Fig. 1 und 2;
- Fig. 4: eine Variante der Anordnung nach Fig. 3 mit gegeneinander höhenversetzt angeordneten Abstandshaltern.

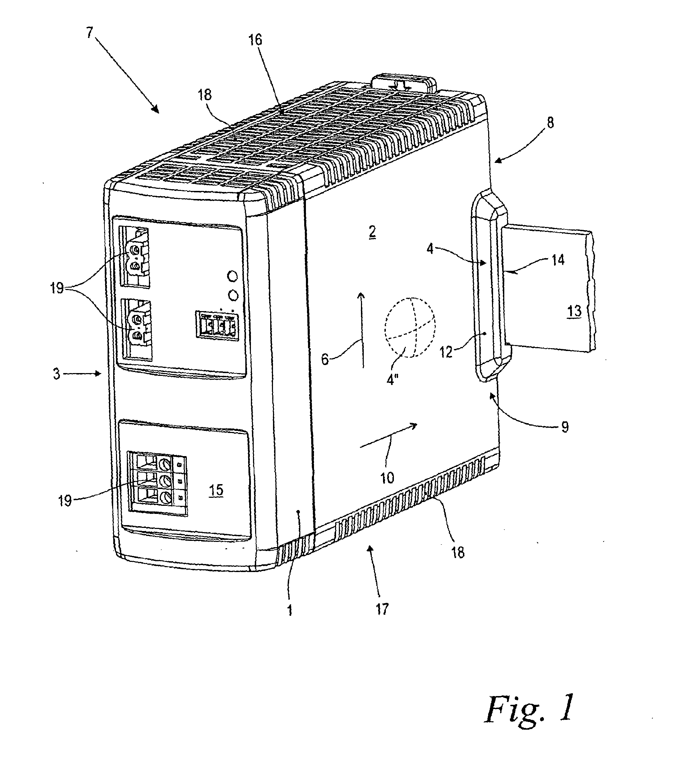

Fig. 1 zeigt in einer perspektivischen Übersichtsdarstellung ein Einbaunetzgerät 7, der an einer angedeuteten Montageschiene 13 in einem nicht dargestellten Schaltschrank oder dergleichen befestigt ist. Das Einbaunetzgerät 7 weist ein Gehäuse 1 mit sich gegenüberliegenden Seitenwänden 2, 3, mit einer oberen und einer unteren Wand 16, 17, mit einer Frontwand 15 und mit einer hinteren Montagewand 8 auf. Das Gehäuse 1 kann als Blechgehäuse, aber auch als Kunststoffgehäuse ausgeführt sein. Beide Gehäuse haben Vorteile.

Im Bereich der Frontwand 15 sind elektrische Anschlüsse 19 für eine Eingangsspannung oder verschiedene Ausgangsspannungen vorgesehen. Die untere Wand 17 und die obere Wand 16 sind jeweils in Form eines Gitters 18 ausgebildet, wodurch sich im Inneren des Netzgeräts 7 in der durch einen Pfeil 6 angedeuteten und durch die gezeigte Montageposition vorgegebenen Hochrichtung ein Konvektionsstrom im Inneren des Gehäuses 1 zur Kühlung ausbilden kann.

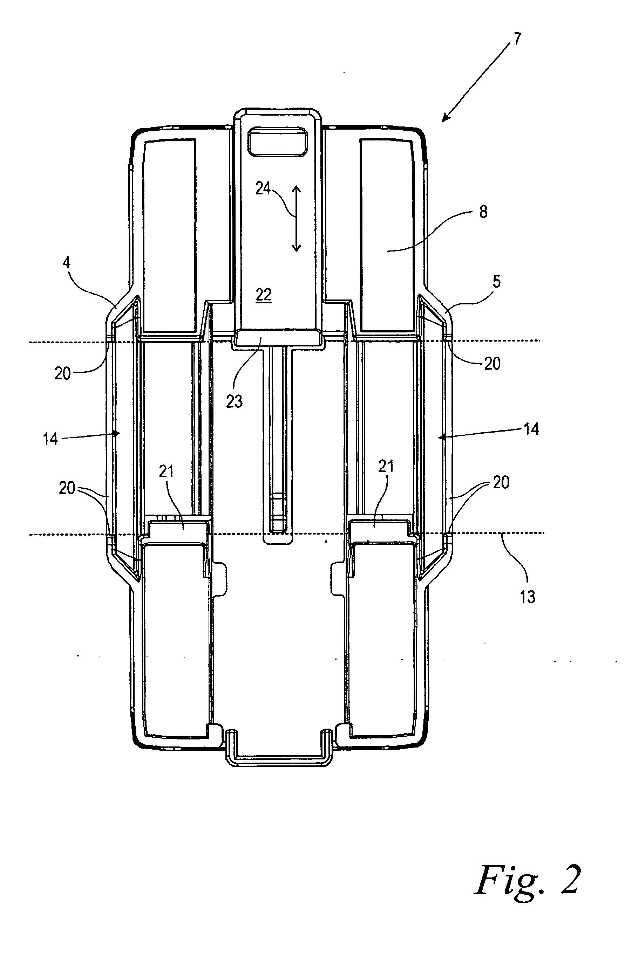

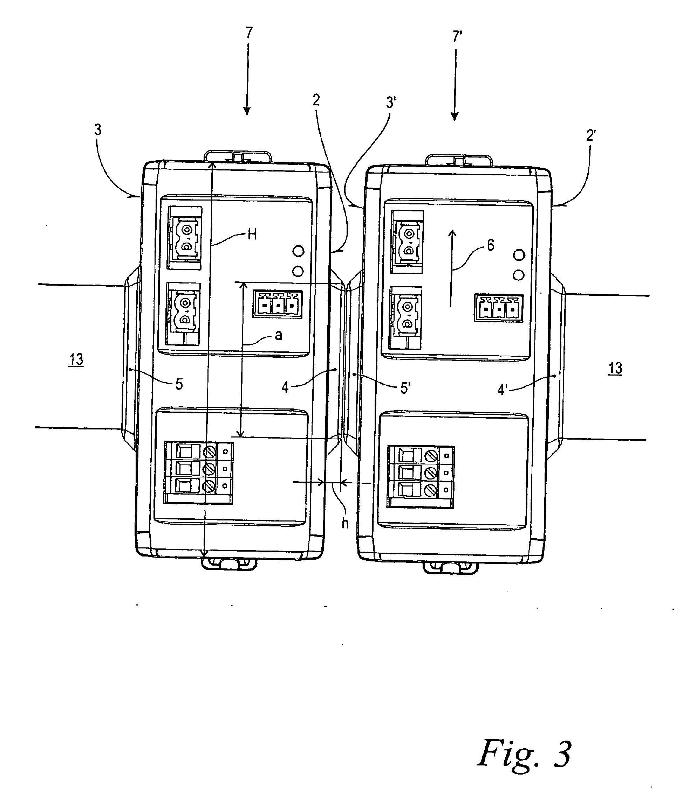

Im Ausführungsbeispiel ist in einem Eckbereich 9, in dem die Seitenwand 2 an die rückwärtige Montagewand 8 angrenzt, ein seitlich über die Kontur des Netzgeräts 7 hervorstehender Abstandshalter 4 angeordnet. Zweckmäßig kann der Abstandshalter 4" auch als Erhebung auf der Seitenfläche 2 ausgebildet sein, wie in Fig. 1 strichliert dargestellt. Die Form des Abstandshalters 4, 4", kann rippenförmig, teilkugelförmig, elliptisch oder dgl. sein. Der gezeigte rippenförmige Abstandshalter 4 weist eine Nut 14 auf, die die Montageschiene 13 etwa formschlüssig anliegend umgreift. Durch einen Pfeil 10 ist eine Montagerichtung angedeutet, in der das Netzgerät 7 montiert und auf die Montageschiene 13 aufgesetzt wird. Der Abstandshalter 4 weist bezogen auf die Montagerichtung 10 eine vorderseitige Montageschräge 12 auf. Spiegelsymmetrisch zu der gezeigten Anordnung ist seitlich im Bereich der gegenüberliegenden Seitenwand 3 ein weiterer, in den Fig. 2 und 3 gezeigter Abstandshalter 5 vorgesehen. Die Abstandshalter 4, 5 sind im gezeigten Ausführungsbeispiel einteilig mit der jeweils zugehörigen Seitenwand 2, 3 ausgebildet, im Ausführungsbeispiel in Form einer länglichen Hohlrippe aus Kunststoff; es kann zweckmäßig sein, anstelle der Hohlrippe eine Rippe aus Vollmaterial vorzusehen.

Fig. 2 zeigt eine Rückansicht des Netzgeräts 7 nach Fig. 1 mit den beiden spiegelsymmetrisch sich gegenüberliegenden Abstandshaltern 4, 5. Die Nut 14 in den Abstandshaltern 4, 5 ist mit drei im rechten Winkel zueinander liegenden Anlageflächen 20 versehen, die die Montageschiene 13 flächig und spielfrei anliegend auf drei Seiten umgreifen. Zur rastenden Festlegung des Netzgeräts 7 an der Montageschiene 13 sind an der Rückwand zwei Haken 21 vorgesehen, die die Montageschiene 13 formschlüssig umgreifen. Ein weiterer, gegenüberliegender Haken 23 ist an einer federnden Lasche 22 vorgesehen und hintergreift ebenfalls die Montageschiene 13. Die Lasche 22 ist in Richtung eines Doppelpfeiles 24 gegen eine Federkraft verschieblich, wodurch das Netzgerät 7 in bezug auf die Montageschiene 13 entriegelt bzw. verriegelt werden kann.

Fig. 3 zeigt in einer Frontansicht eine Anordnung von zwei Netzgeräten 7, 7' nach den Fig. 1 und 2. Die beiden Netzgeräte 7, 7' sind unmittelbar seitlich aneinander angrenzend auf der Montageschiene 13 befestigt, wobei der Abstandshalter 4 des Netzgeräts 7 seitlich und flächig an dem angrenzenden Abstandshalter 5' des benachbarten Netzgeräts 7' anliegt. Die Abstandshalter 4, 4', 5, 5' weisen eine Höhe h auf, die so bemessen ist, daß der entstehende äußere Luftspalt zur Abfuhr der Wärme des entsprechenden Netzgeräts 7, 7' ausreicht. Bei der gezeigten Anordnung beträgt damit der Abstand zwischen den beiden aneinander angrenzenden Seitenwänden 2, 3' das Doppelte der Höhe h, wodurch die im Bereich beider aneinander angrenzenden Seitenwände 2, 3' frei werdende Wärme abgeführt werden kann.

Die Abstandshalter 4, 4', 5, 5' sind bezogen auf die Hochrichtung 6 zumindest in etwa mittig an der zugehörigen Seitenwand 2, 2', 3, 3' angeordnet und liegen in Höhe der ebenfalls mittig verlaufenden Montageschiene 13. Die Abstandshalter 4, 4', 5, 5' weisen bezogen auf die Hochrichtung 6 eine Längserstreckung a auf, die im gezeigten Ausführungsbeispiel etwa ein Drittel einer Höhe H der zugehörigen Seitenwand 2, 2', 3, 3' beträgt.

Die jeweils im Bereich der beiden sich gegenüberliegenden Seitenwände 2, 3 bzw. der beiden sich gegenüberliegenden Seitenwände 2', 3' angeordneten Abstandshalter 4, 5, 4', 5' liegen bezogen auf die Hochrichtung 6 in gleicher Höhe.

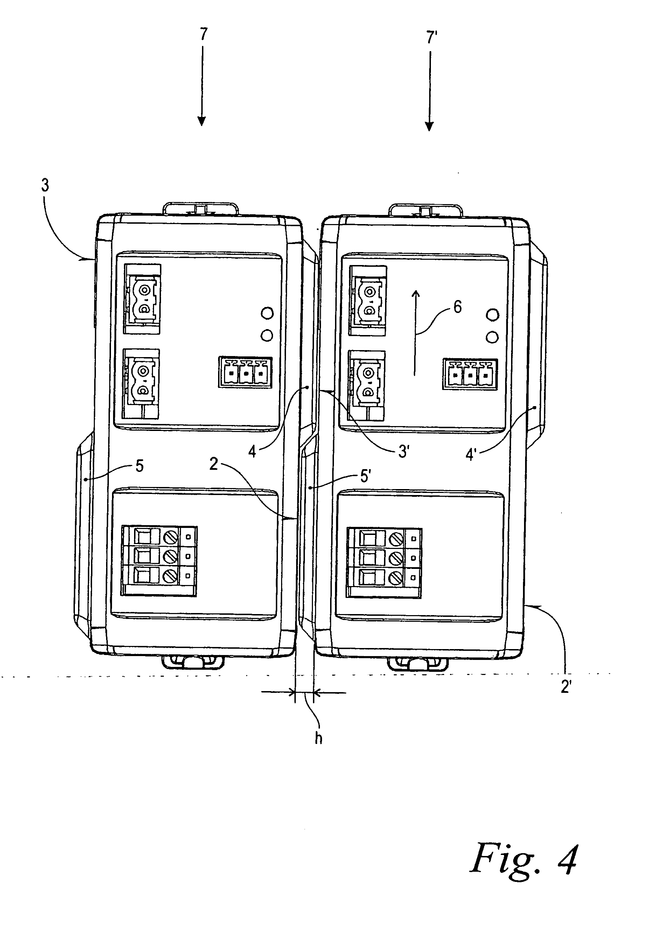

Fig. 4 zeigt eine Variante der Anordnung nach Fig. 3 mit zwei benachbart zueinander montierten, gleichartig aufgebauten Netzgeräten 7, 7'. Im Bereich der beiden sich gegenüberliegenden Seitenwände 2, 3, 2', 3' angeordnete Abstandshalter 4, 5, 4', 5' sind bezogen auf die Hochrichtung 6 derart gegeneinander höhenversetzt, daß die einander zugewandten Abstandshalter 4, 5' der zwei benachbart montierten Netzgeräte 7, 7' nicht aneinander anliegen. Vielmehr liegt der Abstandshalter 4 des Netzgeräts 7 an der Seitenwand 3' des Netzgeräts 7' und der Abstandshalter 5' an der Seitenwand 2 des Netzgeräts 7 an. Die dabei vorgegebene minimale Spaltbreite zwischen den Netzgeräten 7, 7' entspricht dabei der in seitlicher Richtung verlaufenden Höhe h der Abstandshalter 4, 5'. Die Höhe h der Abstandshalter 4, 4', 5, 5' ist so gewählt, daß der entstehende Spalt zwischen den beiden Netzgeräten 7, 7' so breit ist, daß sowohl das Wärmeaufkommen an der Seitenwand 2 als auch an der angrenzenden Seitenwand 3' durch den zwischenliegenden Spalt abgeführt werden kann. In den übrigen Merkmalen und Bezugszeichen stimmt das Ausführungsbeispiel mit dem Ausführungsbeispiel nach den Fig. 1 bis 3 überein. Bei den gezeigten Ausführungsbeispielen ist die der Montageschiene 13 zugewandte Rückwand als Montagewand 8 ausgebildet. Es können auch Ausführungen zweckmäßig sein, bei denen das Netzgerät 7 mit seiner Frontwand 15 beispielsweise an einem Rahmen befestigt ist. Dabei bildet dann die Frontwand 15 die Montagewand 8, in deren Bereich die Abstandshalter 4, 5 angeordnet sein können.

Bestehen die Gehäuse aus Kunststoff, können die Abstandshalter bei entsprechender Formgebung einteilig mit dem Gehäuse gefertigt werden. Bestehen die Gehäuse aus Blech, können die Abstandshalter durch Prägungen oder Abwinklungen aus der Seitenwand gebildet werden.

## Patentansprüche

1. Einbaunetzgerät zum Einbau mit vergleichbaren Netzgeräten oder anderen vergleichbaren elektrischen Einrichtungen nebeneinander auf einer Montageschiene (13) in einen Schaltschrank oder dgl., mit einem Gehäuse (1), welches bezogen auf die vorgesehene Einbauposition zwei Seitenwände (2, 3) aufweist,
**dadurch gekennzeichnet, daß** einteilig mit mindestens einer der beiden Seitenwände (2, 3) mindestens ein Abstandshalter (4, 5) angeordnet ist, so daß die zugehörige Seitenwand (2, 3) in montierter Position des Netzgerätes einen Mindestabstand für eine Luftströmung zu einem benachbarten Gerät oder einem anderen seitlich angeordneten Bauteil aufweist.

2. Netzgerät nach Anspruch 1
**dadurch gekennzeichnet, daß** im Bereich beider Seitenwände (2, 3) je ein Abstandshalter (4, 5) vorgesehen ist.

3. Netzgerät nach Anspruch 1 oder 2,
**dadurch gekennzeichnet, daß** der Abstandshalter (4, 5) bezogen auf eine durch die vorgesehene Einbaulage vorgegebene Hochrichtung (6) eine Längserstreckung (a) aufweist, die insbesondere mindestens etwa ein Drittel einer Höhe (H) der zugehörigen Seitenwand (2, 3) beträgt.

4. Netzgerät nach einem der Ansprüche 1 bis 3,
**dadurch gekennzeichnet, daß** der Abstandshalter (4, 5) bezogen auf die Hochrichtung (6) zumindest in etwa mittig an der zugehörigen Seitenwand (2, 3) angeordnet ist.

5. Netzgerät nach einem der Ansprüche 2 bis 4,
**dadurch gekennzeichnet, daß** zwei im Bereich der beiden sich gegenüberliegenden Seitenwände (2, 3) angeordnete Abstandshalter (4, 5) bezogen auf die Hochrichtung (6) etwa auf gleicher Höhe angeordnet sind.

6. Netzgerät nach einem der Ansprüche 2 bis 4,
**dadurch gekennzeichnet, daß** zwei im Bereich der beiden sich gegenüberliegenden Seitenwände (2, 3) angeordnete Abstandshalter (4, 5) bezogen auf die Hochrichtung (6) gegeneinander höhenversetzt sind, derart, daß die einander zugewandten Abstandshalter (4, 5') zweier benachbart montierter Netzgeräte (7, 7') übereinander liegen.

7. Netzgerät nach einem der Ansprüche 1 bis 6,
**dadurch gekennzeichnet, daß** das Netzgerät (7) eine Montagewand (8) aufweist, wobei der Abstandshalter (4, 5) in einem Eckbereich (9) zwischen der zugehörigen Seitenwand (4, 5) und der Montagewand (8) angeordnet ist.

8. Netzgerät nach einem der Ansprüche 1 bis 7,
**dadurch gekennzeichnet, daß** der Abstandshalter (4, 5) bezogen auf die Montagerichtung (10) des Netzgeräts (7) eine vorderseitige Montageschräge (12) aufweist.

9. Netzgerät nach einem der Ansprüche 1 bis 8,
**dadurch gekennzeichnet, daß** der Abstandshalter (4, 5) mit einer Anlagefläche (20) zur Abstützung gegen eine Montageschiene (13) versehen ist.

10. Netzgerät nach Anspruch 9,
**dadurch gekennzeichnet, daß** der Abstandshalter (4, 5) eine Nut (14) mit insbesondere drei winklig zueinander liegenden, die Montageschiene (13) zumindest teilweise umschließenden Anlageflächen (20) aufweist.

11. Netzgerät nach einem der Ansprüche 1 bis 10,
**dadurch gekennzeichnet, daß** der Abstandshalter (4") als Erhebung in der Seitenwand (2) ausgebildet ist.

## Claims

1. Built-in power supply pack for installation with comparable power supply packs or other comparable electrical devices next to one another on an assembly rail (13) in a switchgear cabinet or the like, comprising a housing (1) which, relative to the provided installation position, has two side walls (2, 3), **characterised in that** at least one spacer (4, 5) is arranged in one piece with at least one of the two side walls (2, 3), so the associated side wall (2, 3), in the assembled position of the power supply pack, has a minimum spacing for an airflow to an adjacent pack or another laterally arranged component.

2. Power supply pack according to claim 1, **characterised in that** a spacer (4, 5) is provided, in each case, in the region of the two side walls (2, 3).

3. Power supply pack according to claim 1 or 2, **characterised in that** the spacer (4, 5), relative to an up direction (6) predetermined by the provided installation position, has a longitudinal extent (a), which is, in particular, at least about a third of a height (H) of the associated side wall (2, 3).

4. Power supply pack according to any one of claims 1 to 3, **characterised in that** the spacer (4, 5), relative to the up direction (6), is arranged at least approximately centrally on the associated side wall (2, 3).

5. Power supply pack according to any one of claims 2 to 4, **characterised in that** two spacers (4, 5) arranged in the region of the two opposing side walls (2, 3), relative to the up direction (6), are arranged approximately at the same height.

6. Power supply pack according to any one of claims 2 to 4, **characterised in that** two spacers (4, 5) arranged in the region of the two opposing side walls (2, 3), relative to the up direction (6), are offset with respect to one another with regard to height, in such a way that the spacers (4, 5'), which face one another, of two adjacently assembled power supply packs (7, 7') lie one above the other.

7. Power supply pack according to any one of claims 1 to 6, **characterised in that** the power supply pack (7) has an assembly wall (8), the spacer (4, 5) being arranged in a corner region (9) between the associated side wall (4, 5) and the assembly wall (8).

8. Power supply pack according to any one of claims 1 to 7, **characterised in that** the spacer (4, 5), relative to the assembly direction (10) of the power supply pack (7), has a front assembly bevel (12).

9. Power supply pack according to any one of claims 1 to 8, **characterised in that** the spacer (4, 5) is provided with a contact face (20) for support against an assembly rail (13).

10. Power supply pack according to claim 9, **characterised in that** the spacer (4, 5) has a groove (14) with, in particular, three contact faces (20) which are located at an angle with respect to one another and at least partially surround the assembly rail (13).

11. Power supply pack according to any one of claims 1 to 10, **characterised in that** the spacer (4") is configured as an elevation in the side wall (2).

## Revendications

1. Bloc d'alimentation intégré pour le montage avec des blocs d'alimentation comparables ou d'autres dispositifs électriques comparables les uns à côté des autres sur un rail de montage (13) dans une armoire de commande ou similaire, avec un boîtier (1) qui présente deux parois latérales (2, 3) par rapport à la position de montage prévue, **caractérisé en ce qu'**au moins un écarteur (4, 5) est disposé d'une seule pièce avec au moins l'une des deux parois latérales (2, 3) de telle sorte que la paroi latérale (2, 3) correspondante présente dans la position montée du bloc d'alimentation un espacement minimum pour un écoulement d'air à un appareil voisin ou un autre composant disposé sur le côté.

2. Bloc d'alimentation selon la revendication 1, **caractérisé en ce qu'**un écarteur (4, 5) est prévu dans la zone des deux parois latérales (2, 3).

3. Bloc d'alimentation selon la revendication 1 ou 2, **caractérisé en ce que** l'écarteur (4, 5) présente par rapport à une direction verticale (6) prédéterminée par la position de montage prévue un étirement longitudinal (a), qui représente en particulier au moins environ un tiers d'une hauteur (H) de la paroi latérale (2, 3) correspondante.

4. Bloc d'alimentation selon l'une quelconque des revendications 1 à 3, **caractérisé en ce que** l'écarteur (4, 5) est disposé par rapport à la direction verticale (6) au moins à peu près au centre sur la paroi latérale (2, 3) correspondante.

5. Bloc d'alimentation selon l'une quelconque des revendications 2 à 4, **caractérisé en ce que** deux écarteurs (4, 5) disposés dans la zone des deux parois latérales (2, 3) qui se font face sont disposés à peu près à la même hauteur par rapport à la direction verticale (6).

6. Bloc d'alimentation selon l'une quelconque des revendications 2 à 4, **caractérisé en ce que** deux écarteurs (4, 5) disposés dans la zone des deux parois latérales (2, 3) qui se font face sont décalés en hauteur de façon réciproque par rapport à la direction verticale (6) de telle sorte que les écarteurs (4, 5') tournés l'un vers l'autre de deux blocs d'alimentation (7, 7') montés à proximité sont disposés l'un au-dessus de l'autre.

7. Bloc d'alimentation selon l'une quelconque des revendications 1 à 6, **caractérisé en ce que** le bloc d'alimentation (7) présente une paroi de montage (8), l'écarteur (4, 5) étant disposé dans une zone d'angle (9) entre la paroi latérale (4, 5) correspondante et la paroi de montage (8).

8. Bloc d'alimentation selon l'une quelconque des revendications 1 à 7, **caractérisé en ce que** l'écarteur (4, 5) présente un chanfrein de montage (12) côté avant par rapport à la direction de montage (10) du bloc d'alimentation (7).

9. Bloc d'alimentation selon l'une quelconque des revendications 1 à 8, **caractérisé en ce que** l'écarteur (4, 5) est doté d'une surface d'appui (20) pour l'appui contre un rail de montage (13).

10. Bloc d'alimentation selon la revendication 9, **caractérisé en ce que** l'écarteur (4, 5) présente une rainure (14) avec en particulier trois surfaces d'appui (20) disposées l'une par rapport à l'autre en formant un angle et entourant au moins partiellement le rail de montage (13).

11. Bloc d'alimentation selon l'une quelconque des revendications 1 à 10, **caractérisé en ce que** l'écarteur (4'') est conçu comme élévation dans la paroi latérale (2).
